# EUROPEAN PATENT SPECIFICATION

(11) **EP 1 207 624 B1**
(45) Date of publication and mention of the grant of the patent: **14.03.2007**
(21) Application number: 01000632.8
(22) Date of filing: 15.11.2001
(51) Int. Cl.: H03M 1/06, H03M 1/36

(54) **Distortion compensation technique for flash-type analog-to-digital converters**
Verzerrungskompensationstechnik für Analog-Digital-Wandler nach dem Parallelverfahren
Technique de compensation de distorsion pour convertisseurs analogique-numérique parallèles

(30) Priority: 15.11.2000 US 713706
(43) Date of publication of application: 22.05.2002
(73) Proprietor: TEXAS INSTRUMENTS INC., Dallas, Texas 75251 (US)
(72) Inventor: Pavan, Shanthi Y., Piscataway, NJ 08834 (US)
(74) Representative: Holt, Michael

(56) References cited:
- EP-A- 0 849 883
- US-A- 4 183 016
- HAGELAUER R ET AL: "A GIGASAMPLE/SECOND 5-B ADC WITH ON-CHIP TRACK AND HOLD BASED ON AN INDUSTRIAL 1-UM GAAS MESFET E/D PROCESS" IEEE JOURNAL OF SOLID-STATE CIRCUITS, IEEE INC. NEW YORK, US, vol. 27, no. 10, 1 October 1992 (1992-10-01), pages 1313-1319, XP000319821 ISSN: 0018-9200

## Description

### FIELD OF THE INVENTION

The present invention relates to analog-to-digital converters, and more particularly, to analog-to-digital converters having a very high operating clock frequency.

### BACKGROUND OF THE INVENTION

Conventional high-speed, analog-to-digital converters ("ADCs") commonly employ a full flash architecture in which the analog-to-digital conversion is performed in parallel by using approximately 2^{N} voltage comparators. An input voltage and fractional portions of a reference voltage are applied simultaneously to each comparator. The fractional portions of the reference voltage are obtained by dividing the reference voltage into equal increments by resistors. The output of each comparator is generally applied to a decoder which decodes such received inputs into a multi-bit digital output representative of the input voltage.

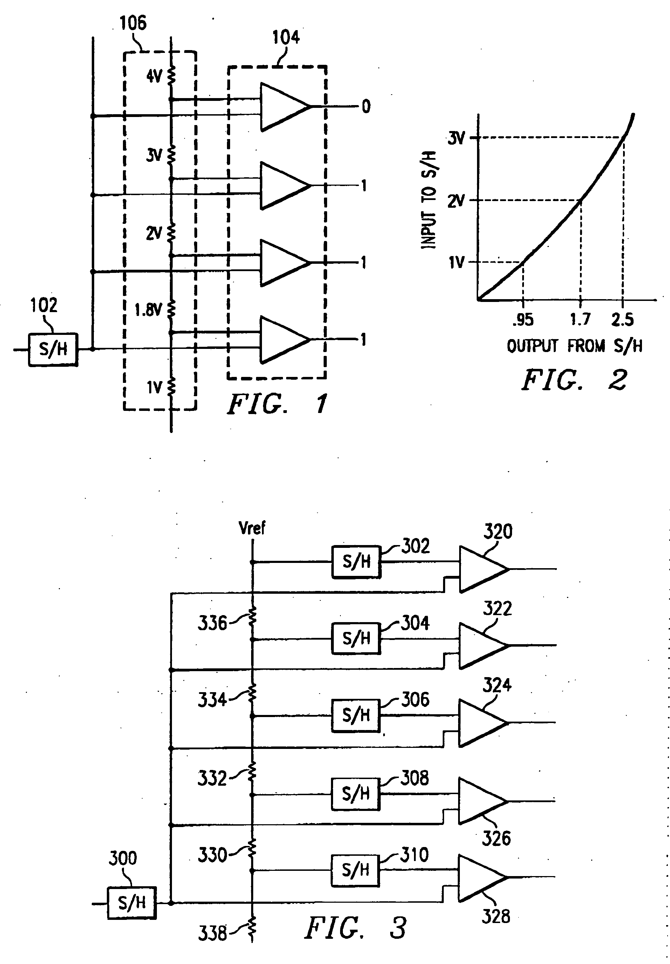

Figure 1 illustrates a typical configuration of a sample-and-hold flash converter. A sample-and-hold circuit 102 is connected to an array of comparators 104. Additionally, Figure 1 illustrates a resistance ladder 106 which is used to provide varying threshold voltages for the comparator array 104. However, the nonlinearity of the sample-and-hold effectively reduces the voltage output from the sample-and-hold circuit. Consequently, inaccurate results can be obtained as a result of the comparison of the output from the sample-and-hold circuit and the threshold voltage from the resistance ladder. Thus, the output of the comparators does not accurately represent the comparison with the output of the sample-and-hold circuit 102 and the threshold voltage from the resistance ladder.

Figure 2 illustrates the input-output characteristic of the sample-and-hold circuit described hereinabove. As illustrated, the input-output characteristic is nonlinear. As the input voltage is increased, the output voltage increases at a slower rate. Consequently, for comparators with a higher threshold voltage, for example with 3 volts input, the comparator designated to receive the 3V as input from the resistance ladder may not receive the 3 volts output from the sample-and-hold circuit to activate the comparator. As illustrated, the sample-and-hole circuit will output 2.5V, not 3.0V, due to the nonlinear characteristics. As a result, the output of the comparator is inaccurate because the comparator will compare 3V from the reference ladder and the output voltage, namely 2.5V, from the output of the sample-and-hold. As a result, the comparator will not be activated as designed. In European Patent Application EP0849883 several techniques for improving sample and hold A/D converters are described, including providing a second holding circuit so that the amplifying circuits may have longer to settle whilst sampling is occurring with a first holding circuit and reducing power consumption due to a reduction in the number of amplifiers required if interpolation is used between samples compared with different reference levels.

### SUMMARY OF THE INVENTION

The present invention provides an analog to digital converter as set forth in the claims.

### BRIEF DESCRIPTION OF THE DRAWINGS

For a more complete understanding of the present invention, reference is now made to the following detailed description of certain particular and illustrative embodiments and the features and aspects thereof, by way of example only, and with reference to the figures of the accompanying drawings in which:
Figure 1 illustrates a prior art ADC;
Figure 2 illustrates an input-output characteristic of the ADC of Figure 1;
Figure 3 illustrates an ADC in accordance with the present invention;
Figures 4, 5 and 6 illustrate output spectrum of an ADC; and
Figure 7 illustrates an alternative embodiment ADC according to the present invention.

### DETAILED DESCRIPTION OF THE PRESENT INVENTION

Figure 3 illustrates a flash converter of the present invention, and more particularly, a sample-and-hold circuit 300 having an output coupled to comparators 320, 322, 324, 326 and 328. In addition, the flash converter includes a resistance ladder including a series of resistors. While in Figure 3, resistors 330, 332, 334, 336 and 338 are shown, any number of resistors could be used in accordance with the teachings of the present invention. More particularly, the resistance ladder includes resistor 338 coupled to ground, resistor 330 coupled to the other end of resistor 338, and resistor 332 coupled to the other end of resistor 330. Resistor 334 is coupled to the other end of resistor 332 with resistor 336 being coupled to the other end of resistor 334. The other end of resistor 336 could be coupled to a reference voltage V_{REF}.

Sample-and-hold circuits 302, 304, 306, 308 and 310 are referred to as replica sample-and-hold circuits because they have similar characteristics to sample-and-hold circuit 300 in terms of current and voltage characteristics. Sample-and-hold circuit 302 is connected between the reference voltage and resistor 336 and is connected to the input of comparator 320. Sample-and-hold circuit 304 is connected between resistor 336 and resistor 334 and connected to comparator 322. Sample-and-hold circuit 306 is connected between resistor 334 and resistor 332 and connected to comparator 324. Sample-and-hold circuit 308 is connected between resistor 332 and resistor 330 and connected to comparator 326. Sample-and-hold circuit 310 is connected between resistor 330 and resistor 338 and connected to comparator 328. Each of sample-and-hold circuits 302, 304, 306, 308 and 310 lower the respective thresholds required for the respective comparators. Each of the sample-and-hold circuits 302, 304, 306, 308 and 310 are replicas of sample-and-hold circuit 300. These replica sample-and-hold circuits could be constructed by making the replica sample-and-hold substantially smaller than the sample-and-hold circuit 300, for example by a factor of 10. Thus, all of the dimensions of the replica sample-and-hold circuits are reduced by the same factor which reduces the power required to operate the replica sample-and-hold. As a consequence, the replica sample-and-hold circuits have substantially the same nonlinearity as the sample-and-hold circuit 300. A smaller sample-and-hold saves power. However, the limiting factor on this sample-and-hold smallness is the output impedance of the regulator which will get significantly larger as the size decreases, resulting in input impedance of the comparator being unacceptable.

One solution is to have an additional sample-and-hold or a replica for each comparator. However, this suffers from the problem of having a large number of replica sample-and-holds and consequently being resultantly expensive. In this solution, all of the voltages are pinned so that the threshold changes in accordance with the nonlinearity of sample-and-hold circuit 300. However, the present invention need not be limited to placing a replica sample-and-hold at each input of a comparator. For voltage ranges where the output of the sample-and-hold circuit 300 is relatively linear, it is not necessary to pin the ladder with a replica sample-and-hold. The term "pin" means that the input to a comparator at a particular reference voltage has a replica sample-and-hold associated with it. It is possible to pin the ladder only at points where it is nonlinear. Thus, the resistance ladder is pinned at specific points. One such circuit is illustrated in Figure 7. Here, two replicas or sample-and-holds are missing. By comparing the circuit of Figure 3 with the circuit of Figure 7, the replica circuits 304 and 306 are missing. Additionally, resistor 340, resistor 342 and resistor 344 have been added. The resistor 340 is connected between the output of sample-and-hold circuit 302 and the input to comparator 320 and the other end of resistor 340 is connected between resistors 336, resistor 334 and comparator 322. Resistor 342 is connected to the input of comparator 322. The other end of resistor 342 is connected between resistor 334, resistor 332 and the input to comparator 324. Additionally, a third resistor resistor 344 is connected between resistors 334 and 332 and the input to comparator 324 and the other end of resistor 344 is connected between the output of sample-and-hold circuit 308 and the input of comparator 326. The voltage between the output of sample-and-hold circuit 302 and sample-and-hold circuit 308 are divided among resistors 340, resistor 342 and resistor 344 in accordance with the relative ratios of the resistance.

One way of achieving the position of where replica sample-and-hold circuits are to be used with comparators is to determine through economics how many replica sample-and-holds are allowable and then choosing comparators which are affected the most by the nonlinear of the sample-and-hold circuit. The comparators where no replica sample-and-holds are required can be determined by interpolation.

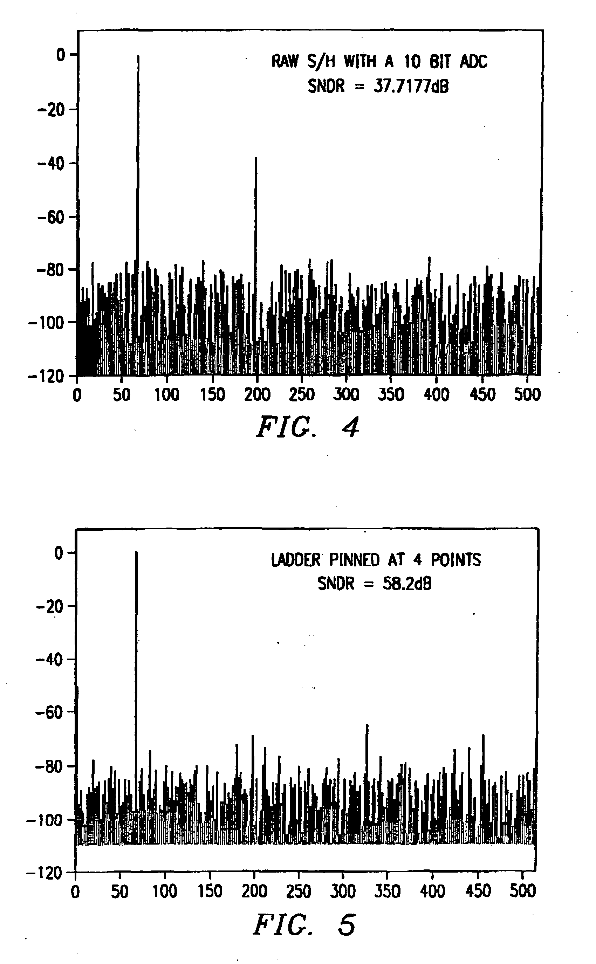

Figure 4 shows the output spectrum of a 10-bit ADC with a nonlinear sample-and-hold circuit. The signal-to-noise ratio is about 37 dB for sinusoidal input.

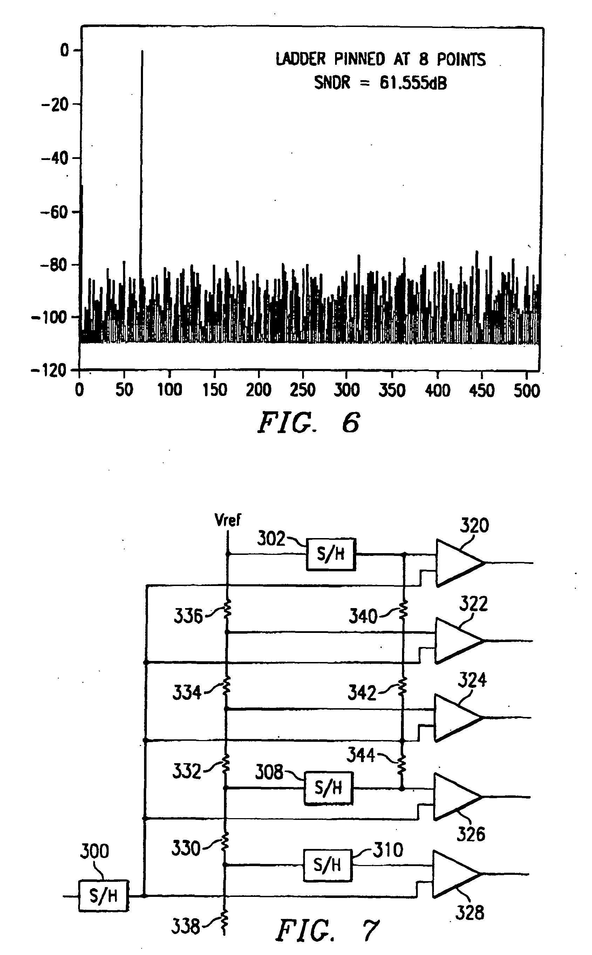

Figure 5 shows the output spectrum of a 10-bit ADC when the reference to the comparator array is pinned at four points, namely with four replica sample-and-holds. The signal-to-noise ratio improves to approximately 58 dB. When eight points are pinned with 8 replica sample-and-hold circuits, as shown in Figure 6, the signal-to-noise ratio is 61.5 dB, very close to the ideal signal-to-noise ratio of a 10-bit converter of 62.03 dB with a linear sample-and-hold circuit.

## Claims

1. An analog-to-digital converter for converting an analog signal to a digital signal, comprising:
a sample-and-hold circuit (300) for sampling said analog signal, holding said analog signal, and for outputting a held analog signal;
a reference circuit for (330, 332, 334, 336, 338) generating a reference voltage to be used as a threshold voltage;
a comparator circuit for (320, 322, 324, 326, 328) comparing said threshold voltage with said held analog signal; **characterised by**
a replica sample-and-hold circuit (302, 304, 306, 308, 310) coupled between said comparator circuit and said reference circuit.

2. An analog-to-digital converter as recited in Claim 1, wherein said replica sample-and-hold circuit is adapted to lower the threshold voltage of said comparator circuit.

3. An analog-to-digital converter as recited in any of Claim 1 or claim 2, wherein said replica sample-and-hold circuit has the similar characteristics to said sample-and-hold circuit.

4. An analog-to-digital converter as recited in any of Claims 1-3, wherein said replica sample-and-hold circuit has substantially the same current characteristics as said sample-and-hold circuit.

5. An analog-to-digital converter as recited in any of Claims 1-4, wherein said replica sample-and-hold circuit has substantially the same voltage characteristics as said sample-and-hold circuit.

## Patentansprüche

1. Analog/Digital-Umsetzer zum Umsetzen eines analogen Signals in ein digitales Signal, mit:
einer Abtast-/Halteschaltung (300) zum Abtasten des analogen Signals, Halten des analogen Signals und Ausgeben eines gehaltenen analogen Signals;
einer Referenzschaltung (330, 332, 334, 336, 338) zum Erzeugen einer Referenzspannung, die als Schwellenspannung verwendet werden soll;
einer Komparatorschaltung (320, 322, 324, 326, 328) zum Vergleichen der Schwellenspannung mit dem gehaltenen analogen Signal; **gekennzeichnet durch**
eine Kopie-Abtast-/Halteschaltung (302, 304, 306, 308, 310), die zwischen die Komparatorschaltung und die Referenzschaltung geschaltet ist.

2. Analog/Digital-Umsetzer nach Anspruch 1, bei dem die Kopie-Abtast-/Halteschaltung so beschaffen ist, dass sie die Schwellenspannung der Komparatorschaltung senken kann.

3. Analog/Digital-Umsetzer nach Anspruch 1 oder Anspruch 2, bei dem die Kopie-Abtast-/Halteschaltung die gleichen Eigenschaften wie die Abtast-/Halteschaltung besitzt.

4. Analog/Digital-Umsetzer nach einem der Ansprüche 1-3, bei dem die Kopie-Abtast-/Halteschaltung im Wesentlichen die gleiche Stromcharakteristik wie die Abtast-/Halteschaltung hat.

5. Analog/Digital-Umsetzer nach einem der Ansprüche 1-4, bei dem die Kopie-Abtast-/Halteschaltung im Wesentlichen die gleiche Spannungscharakteristik wie die Abtast-/Halteschaltung hat.

## Revendications

1. Convertisseur analogique-numérique pour conversion d'un signal analogique en un signal numérique, comprenant :
un circuit d'échantillonnage et de maintien (300) pour échantillonner ledit signal analogique, maintenir ledit signal analogique, et pour fournir en sortie un signal analogique maintenu ;
un circuit de référence (330, 332, 334, 336, 338) pour générer une tension de référence devant être utilisée comme tension de seuil ;
un circuit comparateur (320, 322, 324, 326, 328) pour comparer ladite tension de seuil audit signal analogique maintenu ; **caractérisé par**
un circuit d'échantillonnage et de maintien réplique (302, 304, 306, 308, 310) couplé entre ledit circuit comparateur et ledit circuit de référence.

2. Convertisseur analogique-numérique selon la revendication 1, dans lequel ledit circuit d'échantillonnage et de maintien réplique est adapté pour abaisser la tension de seuil dudit circuit comparateur.

3. Convertisseur analogique-numérique selon l'une quelconque des revendications 1 à 2, dans lequel ledit circuit d'échantillonnage et de maintien réplique présente les caractéristiques similaires à celles dudit circuit d'échantillonnage et de maintien.

4. Convertisseur analogique-numérique selon l'une quelconque des revendications 1 à 3, dans lequel ledit circuit d'échantillonnage et de maintien présente sensiblement les mêmes caractéristiques de courant que ledit circuit d'échantillonnage et de maintien.

5. Convertisseur analogique-numérique selon l'une quelconque des revendications 1 à 4, dans lequel ledit circuit d'échantillonnage et de maintien réplique a sensiblement les mêmes caractéristiques de tension que ledit circuit d'échantillonnage et de maintien.
